# EUROPÄISCHE PATENTSCHRIFT

(11) **EP 0 886 883 B1**
(45) Veröffentlichungstag und Bekanntmachung des Hinweises auf die Patenterteilung: **26.04.2006**
(21) Anmeldenummer: 97915312.9
(22) Anmeldetag: 27.02.1997
(51) Int. Cl.: H01L 27/085, H01L 29/772, H01L 29/739, H01L 27/06

(54) **ELEKTRONISCHE EINRICHTUNG ZUM SCHALTEN ELEKTRISCHER STRÖME, FÜR HOHE SPERRSPANNUNGEN UND MIT GERINGEN DURCHLASSVERLUSTEN**
ELECTRONIC MEANS FOR SWITCHING ELECTRONIC CURRENTS, FOR HIGH OFF-STATE VOLTAGES AND WITH LOW ON-STATE POWER LOSSES
DISPOSITIFS ELECTRONIQUES POUR LA COMMUTATION DE COURANTS ELECTRIQUES, POUR DES TENSIONS DE BLOCAGE ELEVEES ET AVEC DE FAIBLES PERTES D'ENERGIE A L'ETAT CONDUCT

(30) Priorität: 14.03.1996 DE 19610135
(43) Veröffentlichungstag der Anmeldung: 30.12.1998
(73) Patentinhaber: SiCED Electronics Development GmbH & Co KG, 91052 Erlangen (DE)
(72) Erfinder: MITLEHNER, Heinz, D-91080 Uttenreuth (DE); STOISIEK, Michael, D-85521 Ottobrunn (DE)
(74) Vertreter: Berg, Peter
(86) Internationale Anmeldenummer: PCT/DE1997/000352
(87) Internationale Veröffentlichungsnummer: WO 1997/034322

(56) Entgegenhaltungen:
- DE-A- 2 855 546
- US-A- 4 404 575
- PATENT ABSTRACTS OF JAPAN vol. 010, no. 363 (E-461), 5.Dezember 1986 & JP 61 161015 A (HITACHI LTD), 21.Juli 1986,
- MICROELECTRONIC ENGINEERING, Bd. 28, Nr. 1/04, 1.Juni 1995, Seiten 177-184, XP000513457 JAYANT BALIGA B: "CRITICAL NATURE OF OXIDE/INTERFACE QUALITY FOR SIC POWER DEVICES"

## Beschreibung

Zum Schalten elektrischer Ströme werden neben mechanischen Schaltgeräten auch Halbleiterbauelemente eingesetzt. Halbleiterbauelemente kann man unterteilen in stromgesteuerte Halbleiterbauelemente, zu denen bipolare Transistoren und Thyristoren gehören, einerseits und spannungsgesteuerte Halbleiterbauelemente wie beispielsweise die unipolaren MOS(Metal-Oxide-Semiconductor)-Feldeffekttransistoren (MOSFET) oder die bipolaren MOS-gesteuerten Thyristoren (MCT) oder die MOS-gesteuerten bipolaren Transistoren (IGBT) andererseits. Alle genannten Halbleiterbauelemente können nur Ströme in einer Stromrichtung, d. h. nur bei einer bestimmten Polarität der Betriebsspannung, schalten (schaltbarer Zustand). Im schaltbaren Zustand kann das Halbleiterbauelement durch Verändern: der Steuerspannung oder des Steuerstromes von einem Sperrzustand, in dem praktisch kein Strom durch das Halbleiterbauelement fließt, in einen Durchlaßzustand, in dem ein Strom durch das Halbleiterbauelement fließt, geschaltet werden oder umgekehrt. Im Durchlaßzustand ist der durch das Halbleiterbauelement fließende Strom abhängig von dem Betrag der Betriebsspannung und der Steuerspannung bzw, dem Steuerstrom. Jedes Halbleiterbauelement kann in seinem Sperrzustand nur bis zu einer maximalen Sperrspannung (Durchbruchsspannung) sperren. Bei höheren Sperrspannungen geschieht ein Ladungsträgerdurchbruch, der schnell zur Zerstörung des Bauelements führen kann. Für Wechselströme werden in der Regel zwei Halbleiterbauelemente antiparallel geschaltet (Wechselwegschaltung).

Als Halbleitermaterial für Halbleiterbauelemente insbesondere für die Leistungselektronik wird in der Praxis Silicium (Si) verwendet. Für Silicium existiert nämlich eine hochentwickelte Prozeßtechnologie. Außerdem weisen spannungsgesteuerte MOS-Halbleiterbauelemente in Silicium wegen der hohen Ladungsträgerbeweglichkeit von Silicium im Kanalgebiet der MOS-Struktur hohe Schaltgeschwindigkeiten auf. Ein Problem von MOSFETs besteht darin, daß die statische Verluste im Durchlaßzustand um so höher werden, je höher die vom MOSFET zu bewältigenden Sperrspannungen im Sperrzustand sind. In Silicium wird die statische Verlustleistung eines für hohe Sperrspannungen ab etwa 600 V ausgelegten Leistungs-MOSFET bei Durchlaßströmen ab typischerweise etwa 5 A so groß, daß man für diese und höhere Schaltströme und Sperrspannungen bipolare IGBTs in Silicium den Silicium-MOSFETs vorzieht.

Aus der *WO 95*/*24055 A1* ist ein in dem Halbleitermaterial Siliciumcarbid (SiC) gebildeter MOSFET bekannt. Ein solcher Siliciumcarbid-MOSFET kann bei gleicher Sperrfähigkeit von über 600 V mit geringeren Durchlaßverlusten ausgelegt werden als ein Silicium-MOSFET. Jedoch ist die Prozeßtechnologie in Siliciumcarbid, insbesondere für die MOS-Struktur, noch nicht so fortgeschritten wie in Silicium, so daß Silicumcarbid-MOSFETs noch nicht serienmäßig hergestellt werden.

Weiterhin ist aus der JP 61-16105 A eine Anordnung aus der Hintereinanderschaltung eines ersten Transistors mit einem zweiten SIT-Transistor bekannt, welcher letzterer speziell aus einem III-V-Halbleitermaterial besteht. Aufgrund dieses Materials ist die bekannte Anordnung speziell für die Kommunikationselektronik mit vergleichsweise niedrigen Spannungen und hohen Schaltfrequenzen geeignet.

Aus der Veröffentlichung "Solid-State Electronics", Vol. 25, No. 5, pp. 345 bis 353 (1982) mit der Bezeichnung "High Gain Power Switching Using Field Control Thyristors" ist weiterhin eine Leistungsschalteinrichtung auf Halbleiterbasis bekannt, bei der Thyristoren zum Einsatz kommen. Für den Thyristor werden MOSFETs eingesetzt.

Demgegenüber liegt der Erfindung die Aufgabe zugrunde, eine zum Schalten elektrischer Ströme geeignete elektronische Einrichtung anzugeben, die für hohe Sperrspannungen von über 500 V ausgelegt werden kann und dennoch nur geringe Verluste im Durchlaßbetrieb aufweist.

Diese Aufgabe wird gemäß der Erfindung gelöst mit den Merkmalen des Anspruchs 1. Weiterbildungen sind in den abhängigen Ansprüchen angegeben.

Die Erfindung beruht auf der Überlegung, die gute Steuerbarkeit und die vielfältigen Ausführungsformen von Siliciumbauelementen, insbesondere für die Leistungsschalttechnik, mit der hohen Sperrfähigkeit eines p-n-Übergangs in einem Halbleiter mit einer Durchbruchfeldstärke von wenigstens 10⁶ V/cm (Volt pro Zentimeter) in einer besonderen und vorteilhaften Weise zu kombinieren. Die Durchbruchfeldstärke (breakdown field) ist die maximale Feldstärke, die in einem Halbleiter auftreten darf, ohne daß der Halbleiter durch einen Ladungsträgerdurchbruch zerstört wird. Als solches Material wird erfindungsgemäß Siliciumcarbid verwendet.

Die elektronische Einrichtung weist zwei elektrische Anschlüsse zum Anlegen elektrischer Betriebsspannungen, ein Halbleiterbauelement auf Siliciumbasis (Siliciumbauelement) und zusätzlich eine Halbleiteranordnung auf. Die Halbleiteranordnung umfaßt ein erstes Halbleitergebiet eines vorgegebenen Leitungstyps und wenigstens ein weiteres Halbleitergebiet des entgegengesetzten Leitungstyps. Die Halbleitergebiete sind jeweils mit einem Halbleiter mit einer Durchbruchfeldstärke von wenigstens 10⁶ V/cm gebildet. Zwischen den entgegengesetzt leitenden Halbleitergebieten ist jeweils ein p-n-Übergang gebildet. Es ist nun wenigstens ein an den p-n-Übergang angrenzendes Kanalgebiet im ersten Halbleitergebiet der Halbleiteranordnung mit dem Siliciumbauelement elektrisch in Reihe zwischen die beiden Anschlüsse geschaltet. Das Siliciumbauelement weist bei Betriebsspannungen einer vorgegebenen Polarität einen Durchlaßzustand und einen Sperrzustand auf. Im Durchlaßzustand fließt durch das Siliciumbauelement ein elektrischer Strom, während im Sperrzustand ein praktisch vernachlässigbarer Sperrstrom fließt. Der p-n-Übergang der Halbleiteranordnung ist elektrisch zwischen die beiden Anschlüsse in Sperrichtung für die Betriebsspannungen mit der vorgegebenen Polarität geschaltet. Wenn das Siliciumbauelement in seinem Sperrzustand ist, schnürt die Verarmungszone des wenigstens einen p-n-Übergangs das Kanalgebiet im ersten Halbleitergebiet ab oder überdeckt sogar das gesamte Kanalgebiet. Wegen des wesentlich höheren elektrischen Widerstands der Verarmungszone im Vergleich zum Kanalgebiet fällt im Sperrzustand des Siliciumbauelements über der Verarmungsxone des p-n-Übergangs bereits ein großer Anteil der Betriebsspannung zwischen den beiden Anschlüssen ab. Aufgrund der hohen Durchbruchsfeldstärke von wenigstens 10⁶ V/cm des für die Halbleitergebiete des p-n-Übergangs vorgesehenen Halbleiters kann der p-n-Übergang der Halbleiteranordnung deutlich höhere Sperrspannungen tragen als ein in Silicium gebildeter p-n-Übergang mit gleichen Ladungsträgerkonzentrationen und Abmessungen. Die Durchbruchsfeldstärke von Silicium liegt zum Vergleich bei etwa 2-10⁵ V/cm. Das Siliciumbauelement muß deshalb nur für den übrigbleibenden Teil der Sperrspannung zwischen den beiden Anschlüssen ausgelegt werden. Dies wiederum hat eine deutlich reduzierte Verlustleistung des Siliciumbauelements im Durchlaßbetrieb zur Folge. Am p-n-übergang der Halbleiteranordnung liegt ferner im anderen Schaltungszweig die gesamte Betriebsspannung zwischen den beiden Anschlüssen als Sperrspannung an.

Im Durchlaßzustand des Siliciumbauelements wird die Verarmungszone des p-n-Übergangs mit Ladungsträgern überschwemmt und das Kanalgebiet im ersten Halbleitergebiet der Halbleiteranordnung wieder geöffnet. Durch das Kanalgebiet kann nun ein elektrischer Strom zwischen den beiden Anschlüssen fließen. Die gesamte Verlustleistung der elektronischen Einrichtung im Durchlaßbetrieb (stromführenden Betrieb) umfaßt die Verluste im Siliciumbauelement im Durchlaßzustand und die Verluste im ersten Halbleitergebiet der Halbleiteranordnung. Diese Gesamtverluste der elektronischen Einrichtung sind nun bei einer vorgegebenen maximalen Sperrspannung deutlich kleiner als bei einem für diese maximale Sperrspannung ausgelegten Siliciumbauelement vom gleichen Bautyp für sich allein betrachtet und auch kleiner als bei einem für die vorgegebene maximale Sperrspannung ausgelegten Halbleiterbauelement, das vom gleichen Bautyp wie das Siliciumbauelement ist und in dem gleichen Halbleiter wie die Halbleiteranordnung gebildet ist.

In einer hinsichtlich der Herstellung vorteilhaften Ausführungsform ist das wenigstens eine weitere Halbleitergebiet, das mit dem ersten Halbleitergebiet einen p-n-übergang bildet, an einer ersten Oberfläche des ersten Halbleitergebiets angeordnet, vorzugsweise durch Ionenimplantation.

An einer von der ersten Oberfläche des ersten Halbleitergebiets der Halbleiteranordnung abgewandten zweiten Oberfläche dieses ersten Halbleitergebiets ist in einer ersten Weiterbildung eine Elektrode angeordnet, die mit einem Pol der Betriebsspannung elektrisch verbunden werden kann.

In einer anderen Weiterbildung ist an einer von der ersten Oberfläche des ersten Halbleitergebiets der Halbleiteranordnung abgewandten zweiten Oberfläche dieses ersten Halbleitergebiets ein weiteres Halbleitergebiet vom entgegengesetzten Leitungstyp wie das erste Halbleitergebiet angeordnet, und an einer vom ersten Halbleitergebiet abgewandten Oberfläche dieses weiteren Halbleitergebiets ist eine Elektrode angeordnet, die mit einem Pol der Betriebsspannung elektrisch verbunden werden kann. In dieser Ausführungsform ist zwischen die beiden Anschlüsse der elektronischen Einrichtung ein zusätzlicher p-n-Übergang geschaltet.

In einer besonders vorteilhaften Ausführungsform der elektronischen Einrichtung weist die Halbleiteranordnung wenigstens zwei weitere Halbleitergebiete vom entgegengesetzten Leitungstyp wie das erste Halbleitergebiet auf, die jeweils einen p-n-Übergang mit dem ersten Halbleitergebiet bilden. Das wenigstens eine Kanalgebiet wird dann von diesen wenigstens zwei p-n-Übergängen begrenzt. Im Sperrzustand des Siliciumbauelements vereinigen sich die Verarmungszonen der p-n-Übergänge und schließen so als gemeinsame Verarmungszone das Kanalgebiet ab.

Ein bevorzugtes Halbleitermaterial für die Halbleiteranordnung ist Siliciumcarbid (SiC) wegen dessen hervorragenden elektronischen und thermischen Eigenschaften.

Da ein Halbleiter mit einer hohen Durchbruchfeldstärke im allgemeinen auch einen hohen Energiebandabstand zwischen Valenzband und Leitungsband hat, kann die Halbleiteranordnung für höhere Stromdichten ausgelegt werden als das Siliciumbauelement und somit die Gesamtfläche und der Materialbedarf der Halbleiteranordnung reduziert werden. Die mit den höheren Stromdichten verbundene stärkere Erwärmung der Halbleiteranordnung wirkt sich wegen der Temperaturfestigkeit des Halbleiters der Halbleiteranordnung aufgrund dessen hohen Bandabstands nicht nachteilig aus.

Eine besonders vorteilhafte Ausführungsform der elektronischen Einrichtung zeichnet sich dadurch aus, daß das Siliciumbauelement eine MOS-Struktur zum Steuern des Stromflusses und damit des Umschaltens zwischen Durchlaßzustand und Sperrzustand enthält. In dieser Ausführungsform wird die hohe MOS-Kanalbeweglichkeit der Ladungsträger in Silicium ausgenutzt. Ein bevorzugtes Siliciumbauelement ist ein unipolarer Silicium-MOSFET.

Zur weiteren Erläuterung der Erfindung wird auf die Zeichnung Bezug genommen, in deren
- FIG 1: ein Schaltungsaufbau einer elektronischen Einrichtung
- FIG 2 bis 4: jeweils eine Ausführungsform einer Halbleiteranordnung für eine solche elektronische Einrichtung im Querschnitt,
- FIG 5: eine Ausführungsform einer Halbleiteranordnung für eine elektronische Einrichtung in einer Draufsicht und
- FIG 6: eine Schaltung für eine elektronische Einrichtung mit einem Silicium-MOSFET
jeweils schematisch dargestellt sind. Einander entsprechende Teile sind mit denselben Bezugszeichen versehen.

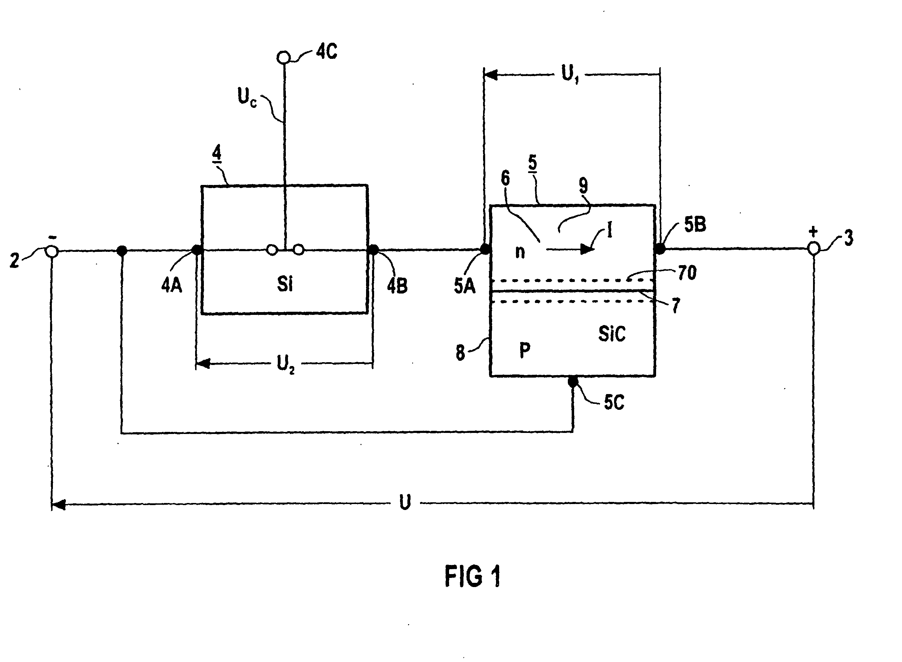

In der Schaltskizze der FIG 1 ist der prinzipielle Aufbau der elektronischen Einrichtung veranschaulicht. Die elektronische Einrichtung umfaßt zwei elektrische Anschlüsse 2 und 3, ein Siliciumbauelement (Halbleiterbauelement auf Basis des Halbleiters Silicium) 4 und eine Halbleiteranordnung 5. Zwischen die beiden Anschlüsse 2 und 3 wird im Betrieb der elektronischen Einrichtung eine Betriebsspannung U angelegt, die zeitlich konstant oder auch veränderlich sein kann.

Das Siliciumbauelement 4 hat einen ersten Anschluß 4A und einen zweiten elektrischen Anschluß 4B sowie einen Steueranschluß 4C. Bei einer bestimmten Polarität einer zwischen den Anschlüssen 4A und 4B anliegenden Spannung U₂ befindet sich das Siliciumbauelement in einem schaltbaren Zustand (Schaltzustand, Schaltrichtung) und kann in Abhängigkeit von einer an dem Steueranschluß 4C anlegbaren Steuerspannung U_{C} oder einem Steuerstrom einen elektrischen Strom zwischen den beiden Anschlüssen 4A und 4B durchschalten oder ausschalten. Mit Hilfe der Steuerspannung U_{C} oder des Steuerstroms kann also das Siliciumbauelement 4 bei der vorgegebenen Polarität der Spannung U₂ von einem Durchlaßzustand (stromführender Zustand) in einen Sperrzustand (stromloser Zustand) oder umgekehrt gebracht werden. Bei der entgegengesetzten Polarität der Spannung U₂ zwischen den beiden Anschlüssen 4A und 4B befindet sich das Siliciumbauelement 4 in einem nicht schaltbaren Zustand und ist dann nicht mehr durch die Steuerspannung U_{C} bzw. den Steuerstrom steuerbar.

Die Halbleiteranordnung 5 umfaßt ein erstes Halbleitergebiet 6 eines Leitungstyps und wenigstens ein an das erste Halbleitergebiet 6 angrenzendes weiteres Halbleitergebiet 8 vom entgegengesetzten Leitungstyp wie das erste Halbleitergebiet 6. Die Halbleitergebiete 6 und 8 der Halbleiteranordnung 5 bestehen jeweils aus einem Halbleitermaterial mit einer Durchbruchfeldstärke von wenigstens 10⁶ V/cm. Geeignete Halbleitermaterialien sind Diamant, Aluminiumnitrid (A1N), Galliumnitrid (GaN), Indiumnitrid (InN) und vorzugsweise Siliciumcarbid (SiC), vorzugsweise der Polytypen 4H und/oder 6H. Zwischen den beiden Halbleitergebieten 6 und 8 ist ein p-n-Übergang 7 gebildet mit einer Verarmungszone (Raumladungszone, Sperrschicht) 70. Die Verarmungszone 70 entsteht durch Ladungsträgerdiffusion zwischen den beiden Halbleitergebieten 6 und 8 und zeichnet sich durch einen sehr hohen elektrischen Widerstand aus im Vergleich zu den Halbleitergebieten 6 und 8. Die Ausdehnung der Verarmungszone 70 ist abhängig von einer am p-n-Übergang 7 anliegenden Spannung (Potentialdifferenz) zwischen den beiden Halbleitergebieten 6 und 8.

Dem ersten Halbleitergebiet 6 sind zwei elektrische Kontakte 5A und 5B der Halbleiteranordnung 5 zugeordnet, die über ein Kanalgebiet 9 im ersten Halbleitergebiet 6 miteinander verbunden sind. Das Kanalgebiet 9 wird in seiner Ausdehnung von der Verarmungszone 70 des p-n-Übergangs 7 begrenzt. Dem zweiten Halbleitergebiet 8 ist ein weiterer Kontakt 5C der Halbleiteranordnung 5 zugeordnet, über den das zweite Halbleitergebiet 8 mit dem ersten Anschluß 2 der elektronischen Einrichtung elektrisch verbunden ist. Der erste Kontakt 5A am Kanalgebiet 9 ist mit dem zweiten Anschluß 4B des Siliciumbauelements 4 elektrisch verbunden. Der erste Anschluß 4A des Siliciumbauelements 4 ist mit dem ersten Anschluß 2 der elektronischen Einrichtung elektrisch verbunden. Somit sind das Siliciumbauelement 4 und das Kanalgebiet 9 elektrisch in Reihe zwischen die beiden Anschlüsse 2 und 3 der elektronischen Einrichtung geschaltet. Der zweite Kontakt 5B der Halbleiteranordnung 5 am Kanalgebiet 9 ist mit dem zweiten Anschluß 3 der elektronischen Einrichtung elektrisch verbunden. Dadurch ist der p-n-Übergang 7 elektrisch zwischen die beiden Anschlüsse 2 und 3 geschaltet.

Die Leitungstypen der den p-n-Übergang 7 bildenden Halbleitergebiete 6 und 8 sind nun so gewählt, daß der p-n-Übergang 7 der Halbleiteranordnung 5 sperrt, wenn an den Anschlüssen 2 und 3 eine Betriebsspannung U in Schaltrichtung für das Siliciumbauelement 4 anliegt. Da der p-n-Übergang 7 somit insbesondere auch dann in Sperrichtung gepolt ist, wenn das Siliciumbauelement 4 im Sperrzustand ist, trägt seine Verarmungszone 70 bis zu einem Maximalwert der Sperrspannung, der sogenannten Durchbruchspannung, praktisch die gesamte Sperrspannung U zwischen den Anschlüssen 2 und 3. Im in FIG 1 dargestellten Ausführungsbeispiel wird davon ausgegangen, daß das Siliciumbauelement 4 in Schaltrichtung gepolt (geschaltet) ist, wenn das elektrische Potential an seinem ersten Anschluß 4A negativ gegenüber dem Potential an seinem zweiten Anschluß 4B ist. Dies entspricht dem Fall, daß am ersten Anschluß 2 der elektronischen Einrichtung der Minuspol der Betriebsspannung U und am zweiten Anschluß 3 der Pluspol der Betriebsspannung U anliegt. Somit sind also das mit dem zweiten Anschluß 3 elektrisch verbundene erste Halbleitergebiet 6 der Halbleiteranordnung 5 n-leitend und das mit dem ersten Anschluß 2 elektrisch verbundene zweite Halbleitergebiet 8 der Halbleiteranordnung 5 p-leitend gewählt. Bei einer umgekehrten Polarität (Direktionalität) des Siliciumbauelements 4 sind die Leitungstypen der beiden den p-n-Übergang 7 bildenden Halbleitergebiete 6 und 8 gerade zu vertauschen.

Vernachlässigt man die geringen Spannungsabfälle der elektrischen Verbindungen, so teilt sich die Betriebsspannung U im Schaltungszweig mit dem Siliciumbauelement 4 in zwei Spannungsanteile U₁ und U₂ auf. Der erste Spannungsanteil U₁ fällt zwischen den Kontakten 5A und 5B der Halbleiteranordnung 5 ab. Der zweite Spannungsanteil U₂ fällt zwischen den Anschlüssen 4A und 4B des Siliciumbauelements 4 ab. Im anderen Schaltungszweig fällt praktisch die gesamte Betriebsspannung U über'der Verarmungszone 70 des p-n-Übergangs 7 der Halbleiteranordnung 5 ab.

In FIG 1 ist das Siliciumbauelement 4 in seinem Durchlaßzustand dargestellt, angedeutet durch den geschlossenen Schalterkontakt. Da nun durch das Siliciumbauelement 4 ein elektrischer Strom I fließt, werden Ladungsträger in die Verarmungszone 70 des p-n-Übergangs 7 injiziert. Dadurch weicht die Verarmungszone 70 zurück und weist eine verhältnismäßig kleine, durch die verbleibende Sperrspannung zwischen den Kontakten 5B und 5C bestimmte Ausdehnung auf. Das Kanalgebiet 9 wird somit geöffnet, und der elektrische Strom I kann durch die Reihenschaltung aus Siliciumbauelement 4 und Kanalgebiet 9 des ersten Halbleitergebiets 6 der Halbleiteranordnung 5 fließen. Das Kanalgebiet 9 der Halbleiteranordnung 5 steht dabei im allgemeinen praktisch vollständig als Strompfad für den elektrischen Strom I zur Verfügung.

Bringt man nun durch Ändern der Steuerspannung U_{C} bei gleicher Polarität der Betriebsspannung U das Siliciumbauelement 4 in seinen Sperrzustand, so dehnt sich die Verarmungszone 70 des p-n-Übergangs 7 aus und unterbricht den Strompfad (elektrisch halbleitendes Gebiet) im Kanalgebiet 9. Das Kanalgebiet 9 kann durch die Ausräumung von Ladungsträgern entweder von der Verarmungszone 70 abgeschnürt werden, d.h. wenigstens in einem Teilbereich quer zur Stromrichtung unterbrochen werden, oder sogar ganz überdeckt werden. Dazu werden die geometrischen Abmessungen des ersten Halbleitergebiets 6 und des zweiten Halbleitergebiets 8 und die über die Dotierung einzustellenden Ladungsträgerkonzentrationen in den beiden Halbleitergebieten 6 und 8 vorzugsweise so gewählt, daß das elektrische Potential am Kontakt 5A der Halbleiteranordnung 5 immer unterhalb der Durchbruchspannung (maximale Sperrspannung) Uₘₐₓ des Siliciumbauelements 4 liegt. Dann ist gewährleistet, daß eine für die durch das Siliciumbauelement 4 vorgegebene Durchbruchspannung Uₘₐₓ ausreichende breite Teilzone der Verarmungszone 70 elektrisch zwischen die Kontakte 5A und 5B geschaltet ist und das Siliciumbauelement 4 nicht zerstört wird. Vorzugsweise wird das erste Halbleitergebiet 6 zumindest im Kanalgebiet 9 niedriger dotiert als das zweite Halbleitergebiet 8. Die Verarmungszone 70 des p-n-Übergangs 7 dehnt sich dann stärker in das erste Halbleitergebiet 6 aus mit dem Vorteil einer besseren Aussteuerbarkeit der Steuerung des Bahnwiderstands des Kanalgebiets 9 durch die Verarmungszone 70. Über der einen hohen elektrischen Widerstand aufweisenden Verarmungszone 70 fällt nun zwischen den Kontakten 5A und 5B der Halbleiteranordnung 5 ein Spannungsanteil U₁ der als Sperrspannung wirkenden Betriebsspannung U ab.

Das Siliciumbauelement 4 kann ein handelsübliches Halbleiterbauelement auf Siliciumbasis sein, vorzugsweise ein spannungsgesteuertes MOS(Metal-Oxide-Semiconductor)-Bauelement (Power MOS device). Bei einem MOS-spannungsgesteuerten Siliciumbauelement 4 ist der Steueranschluß 4C der Gateanschluß der MOS-Struktur. Besonders geeignet als Siliciumbauelement 4 ist ein Leistungs-MOSFET (Metal-Oxide-Semiconductor-Field-Effect-Transistor) in Silicium, vorzugsweise vom Normallyoff-Typ. Als Siliciumbauelement 4 kann aber auch ein Silicium-MESFET (Metal-Semiconductor-Field-Effect-Transistor) verwendet werden.

Da die Halbleiteranordnung 5 im Sperrzustand des Siliciumbauelements 4 den Spannungsanteil U₁ der Betriebssperrspannung U übernimmt, muß das Siliciumbauelement 4 nicht mehr für die gesamte maximale Betriebssperrspannung Uₘₐₓ ausgelegt werden. Die Halbleiteranordnung 5 wird vorzugsweise für die maximale Betriebsspannung Uₘₐₓ zwischen den beiden Anschlüssen 2 und 3 der elektronischen Einrichtung ausgelegt. Das Siliciumbauelement 4 wird im allgemeinen für eine maximale Sperrspannung (Durchbruchspannung) an seinen zwei Anschlüssen 4A und 4B von unter 350 V, insbesondere unter 100 V und vorzugsweise unter 50 V ausgelegt. Beispielsweise kann ein MOSFET der Firma Siemens vom Typ BSM 101 AR mit einer maximalen Sperrspannung von 50 V, einem Durchlaßwiderstand von 3 mΩ und einer gewünschten Nennstromtragfähigkeit im Durchlaßbetrieb verwendet werden. Bei Durchbruchspannungen unter etwa 350 V ist der Kanalwiderstand der MOS-Strukur größer als der Driftwiderstand im Siliciumbauelement 4. Vorzugsweise ist die Durchbruchspannung des Siliciumbauelements 4 so niedrig gewählt, daß der Driftwiderstand des Siliciumbauelements 4 vernachlässigbar gegenüber dessen Kanalwiderstand ist, beispielsweise höchstens das 0.2fache des Kanalwiderstands beträgt. Die Durchlaßverluste eines Siliciumbauelements 4 mit 50 V maximaler Sperrspannung sind beispielsweise wesentlich geringer als bei einem Siliciumbauelement 4, das für eine Sperrspannung von 600 V ausgelegt ist. Da nun wegen der hohen Durchschlagsfestigkeit des Halbleiters der Halbleiteranordnung 5 die geometrischen Abmessungen des ersten Halbleitergebiets 6 gegenüber Silicium für die gleiche Sperrspannung deutlich geringer eingestellt werden können, kann auch der Driftwiderstand in der Halbleiteranordnung 5 klein gehalten werden. Durch die Kombination des Nieder-Volt-Siliciumbauelements 4 mit der hochsperrenden Halbleiteranordnung 5 hat die elektronische Einrichtung somit auch bei hohen Sperrspannungen über 500 V nur geringe Durchlaßverluste.

Die Sperrfähigkeit des p-n-Übergangs 7 der Halbleiteranordnung 5 wird bei gegebenen Halbleitermaterialien durch die geometrischen Abmessungen und die Dotierungen der Halbleitergebiete 6 und 8 der vorgegebenen maximalen Betriebssperrspannung Uₘₐₓ angepaßt. Die Abmessungen werden bei vorgegebenen Dotierungen für größere maximale Sperrspannungen Uₘₐₓ größer gewählt. Bei vorgegebenen Abmessungen wird die Dotierung des ersten Halbleitergebiets 6 zumindest im Kanalgebiet 9 um so kleiner gewählt, je größer die gewünschte maximale Sperrspannung Uₘₐₓ ist. Typische Werte für die n-Dotierung des dargestellten ersten Halbleitergebiets 6 bei Verwendung von Siliciumcarbid des 4H-Polytyps als Halbleitermaterial sind n = 1 · 10¹⁶ cm⁻³ für eine maximale, am p-n-Übergang 7 anliegende Sperrspannung Uₘₐₓ = 600 V, n = 8 · 10¹⁵ cm⁻³ für Uₘₐₓ = 1200 V und n = 5 · 10¹⁵ cm⁻³ für Uₘₐₓ = 1800 V. Aufgrund der hohen Durchbruchfestigkeit des Halbleitermaterials der Halbleiteranordnung 5 ist die Sperrfähigkeit der Verarmungszone 70 des p-n-Übergangs 7 sehr viel höher als sie in Silicium wäre. Somit kann vorzugsweise auch die absolute Ausdehnung der Halbleitergebiete 6 und 8 klein gewählt werden. Bei dem Halbleitermaterial Siliciumcarbid (SiC) können beispielsweise um einen Faktor 10 kleinere Abmessungen als in Silicium gewählt werden. Dies hat einen um denselben Faktor 10 verminderten Bahnwiderstand und damit entsprechend geringere Durchlaßverluste in der Halbleiteranordnung 5 zur Folge.

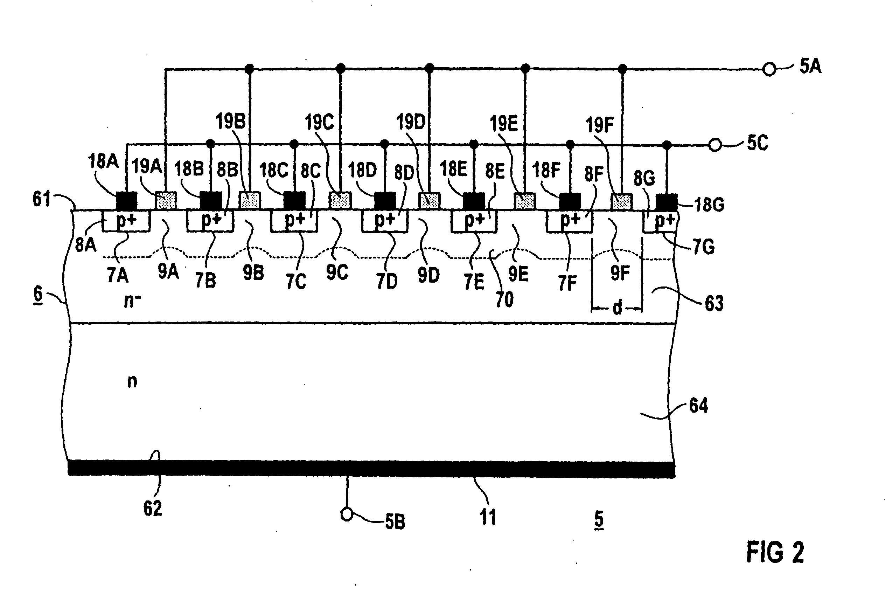

Die FIG 2 bis 5 zeigen jeweils eine vorteilhafte Ausführungsform einer Halbleiteranordnung, die als Halbleiteranordnung 5 in der elektronische Einrichtung gemäß FIG 1 eingesetzt werden kann.

FIG 2 zeigt eine erste vorteilhafte Ausführungsform einer Halbleiteranordnung in einem Querschnitt. Das erste Halbleitergebiet 6 umfaßt ein Substrat 64 eines Leitungstyps (im Beispiel der Figur vom n-Leitungstyp) und eine auf diesem Substrat 64 angeordnete, vorzugsweise epitaktisch aufgewachsene Halbleiterschicht 63 vom gleichen Leitungstyp wie das Substrat 64. Vorzugsweise ist die Halbleiterschicht 63 niedriger dotiert (n- dotiert) als das Substrat 64 (n-dotiert). Die vom Substrat 64 abgewandte Oberfläche der Halbleiterschicht 63 bildet eine erste Oberfläche 61 des ersten Halbleitergebiets 6. Die von der Halbleiterschicht 63 abgewandte Oberfläche des Substrats 64 bildet eine zweite Oberfläche 62 des ersten Halbleitergebiets 6.

An der ersten Oberfläche 61 des ersten Halbleitergebiets 6 sind mehrere weitere Halbleitergebiete 8A, 8B, 8C, 8D, 8E, 8F und 8G zueinander beabstandet angeordnet, die jeweils vom entgegengesetzten Leitungstyp (im Beispiel der Figur vom p-Leitungstyp) wie das erste Halbleitergebiet 6 sind und vorzugsweise durch Ionenimplantation in die Halbleiterschicht 63 erzeugt sind. Die Halbleitergebiete 8A bis 8G (p⁺-Gebiete) sind vorzugsweise im wesentlichen gleich dotiert mit gleichen Dotiertiefenprofilen. Die mit der Halbleiterschicht 63 und jeweils einem der weiteren, entgegengesetzt dotierten Halbleitergebiete 8A bis 8G gebildeten, zugehörigen p-n-Übergänge sind entsprechend mit 7A bis 7G bezeichnet. Vorzugsweise sind die weiteren Halbleitergebiete 8A bis 8G jeweils höher dotiert (p⁺) als die Halbleiterschicht 63. An der Oberfläche jedes der weiteren Halbleitergebiete 8A bis 8G ist jeweils eine Elektrode 18A bzw. 18B bzw. 18C bzw. 18D bzw. 18E bzw. 18F bzw. 18G angeordnet. Diese Elektroden 18A bis 18G sind elektrisch miteinander und mit dem dritten Anschluß 5C der Halbleiteranordnung 5 verbunden. Zwischen jeweils zwei der Halbleitergebiete 8A bis 8G ist in der Halbleiterschicht 63 jeweils ein im wesentlichen vertikal zur ersten Oberfläche 61 verlaufendes und bis an diese erste Oberfläche 61 reichendes Kanalgebiet 9A (zwischen den Halbleitergebieten 8A und 8B), 9B (zwischen den Halbleitergebieten 8B und 8C), 9C (zwischen den Halbleitergebieten 8C und 8D), 9D (zwischen den Halbleitergebieten 8D und 8E), 9E (zwischen den Halbleitergebieten 8E und 8F), bzw. 9F (zwischen den Halbleitergebieten 8F und 8G) gebildet. Jedem der Kanalgebiete 9A bis 9F ist zur elektrischen Kontaktierung an der ersten Oberfläche 61 der Halbleiterschicht 63 eine Elektrode 19A bzw. 19B bzw. 19C bzw. 19D bzw. 19E bzw. 19F zugeordnet. Alle Elektroden 19A bis 19F sind elektrisch mit dem ersten Anschluß 5A der Halbleiteranordnung 5 verbunden. Die Elektroden 18A bis 18G einerseits und die Elektroden 19A bis 19F andererseits werden durch ein nicht dargestelltes Dielektrikum elektrisch voneinander isoliert und können jeweils mit einem Metall oder insbesondere bei Siliciumcarbid als Halbleiter für die Halbleiteranordnung 5 auch mit Polysilicium gebildet sein.

An der zweiten Oberfläche 62 des ersten Halbleitergebiets 6 an der Rückseite des Substrats 64 ist eine vorzugsweise großflächige Elektrode 11 angeordnet, die mit dem zweiten Anschluß 5B der Halbleiteranordnung 5 elektrisch verbunden ist.

Im Durchlaßbetrieb fließt zwischen den beiden Anschlüssen 5A und 5B ein elektrischer Strom durch die Kanalgebiete 9A bis 9F, die Halbleiterschicht 63 und das Substrat 64 in einer bezogen auf die Oberflächen 61 und 62 im wesentlichen vertikalen Stromrichtung. Diese Ausführungsform der Halbleiteranordnung 5 gemäß FIG 2 kann deshalb mit einem vertikalen Junction-Field-Effect-Transistor (JFET) verglichen werden.

Die Abstände zwischen benachbarten Halbleitergebieten 8A und 8B bzw. 8B und 8C usw. bestimmen die Kanalweite der Kanalgebiete 9A bis 9F. Vorzugsweise sind diese Abstände alle kleiner als die Weiten (Ausdehnungen) der Verarmungszonen der p-n-Übergänge 7A bis 7G bei maximaler Betriebssperrspannung Uₘₐₓ zwischen den Anschlüssen 5B und 5C. Dadurch überlappen sich im stromlosen Fall (Sperrbetrieb) die einzelnen Verarmungszonen der p-n-Übergänge 7A bis 7G zu einer gemeinsamen Verarmungszone 70, die vorzugsweise alle Kanalgebiete 9A bis 9F überdeckt und in die Halbleiterschicht 63 ausgedehnt ist. Je kleiner die Abstände zwischen jeweils zwei benachbarten Halbleitergebieten 8A bis 8G bei einer vorgegebenen maximalen Betriebssperrspannung Uₘₐₓ sind, desto planarer wird die gemeinsame Verarmungszone 70, so daß die Sperrfähigkeit durch die "Inselstruktur" der Halbleitergebiete 8A bis 8G (p' - Gebiete) und deren gekrümmten Verlauf nicht wesentlich beeinflußt wird. Vorzugsweise sind die Abstände zwischen den Halbleitergebieten 8A bis 8G im wesentlichen gleich einem festen Abstand d. Der Abstand d oder die Abstände zwischen den Halbleitergebieten 8A bis 8G und sind im allgemeinen zwischen etwa 5 µm und etwa 20 µm gewählt. Die Bemessung der Abstände bzw. des Abstandes d zwischen den Halbleitergebieten 8A bis 8G ist insbesondere abhängig von der Durchbruchspannung des gewählten, in FIG 2 nicht dargestellten Siliciumbauelements 4. Die Differenz zwischen dem elektrischen Potential an den Elektroden 18A bis 18G und dem elektrischen Potential am nicht dargestellten Anschluß 2 sollte betragsmäßig unter und vorzugsweise deutlich unter der Durchbruchspannung des Siliciumbauelements 4 liegen, um eine Zerstörung des Siliciumbauelements 4 zu vermeiden.

Die Halbleitergebiete 8A bis 8G können einzelne, voneinander getrennte Gebiete (Inseln) sein oder auch beabstandete Teilgebiete eines zusammenhängenden Gebiets sein. Die Dicke der Halbleiterschicht 63 wird natürlich ebenfalls ausreichend groß für die maximale Sperrspannung Uₘₐₓ gewählt.

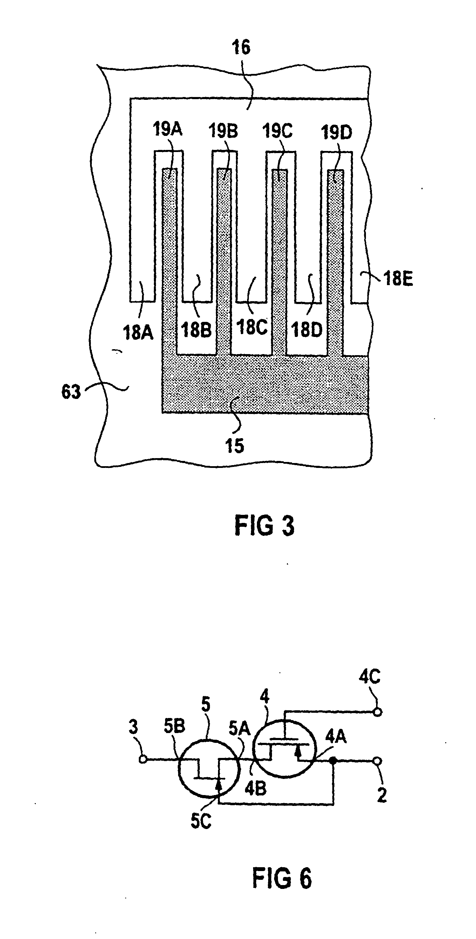

FIG 3 zeigt eine Draufsicht auf die erste Oberfläche 61 des ersten Halbleitergebiets 6 einer Halbleiteranordnung 5 gemäß FIG 2 mit kammartig über einen Leiterstreifen 16 zusammenhängenden Elektroden 18A bis 18E und kammartig über einen Leiterstreifen 15 zusammenhängenden Elektroden 19A bis 19D, die in die Lücken zwischen den Elektroden 18A bis 18E eingreifen. Diese kammartig verzahnte Elektrodenstruktur kann mit einer Einlagenmetallisierung hergestellt werden. Die unter den Elektroden 18A bis 18G liegenden Halbleitergebiete 8A bis 8G werden dann vorzugsweise inselförmig ausgebildet.

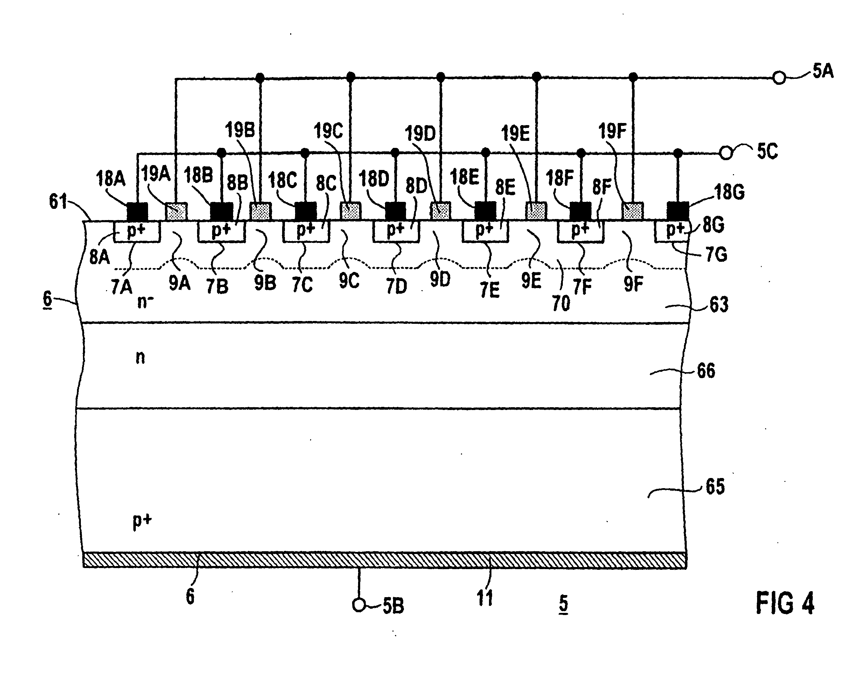

In FIG 4 ist eine Weiterbildung der Halbleiteranordnung 5 gemäß FIG 2 dargestellt. Die Halbleiterschicht 63 (n⁻) ist nun über eine Pufferschicht 66 auf einem entgegengesetzt dotierten (p⁺) Substrat 65 angeordnet. Die Pufferschicht 66 ist im allgemeinen ebenfalls aus einem Halbleiter mit einer Durchbruchfeldstärke von wenigstens 10⁶ V/cm gebildet. Die Pufferschicht 66 ist in der dargestellten Ausführungsform vom gleichen Leitungstyp (n⁺) wie die Halbleiterschicht 63 und vorzugsweise höher dotiert (n⁺) als die Halbleiterschicht 63, insbesondere in einer Realisierung eines Punch-through-Typs, bei dem die Raumladungszone 70 bis zur Pufferschicht 66 durchstößt. Pufferschicht 66 und Halbleiterschicht 63 bilden gemeinsam das erste Halbleitergebiet 6 der Halbleiteranordnung 5. In einer nicht dargestellten Ausführungsform ist die Pufferschicht 66 dagegen vom gleichen Leitungstyp (p) wie das Substrat 65.

In der Ausführungsform gemäß FIG 4 ist somit ein zusätzlicher p-n-Übergang in die Halbleiteranordnung 5 eingebracht, der zwischen die Anschlüsse 5A und 5C geschaltet ist. In der elektronischen Einrichtung gemäß FIG 1 ist dieser zusätzliche p-n-Übergang zwischen die beiden Anschlüsse 2 und 3 elektrisch in Reihe zum Siliciumbauelement 4 und den Kanalgebieten 9A bis 9F (9 in FIG 1) geschaltet. Diese Ausführungsform der FIG 4 ist mit einem IGBT (Insulated-Gate-BipolarTransistor) vergleichbar.

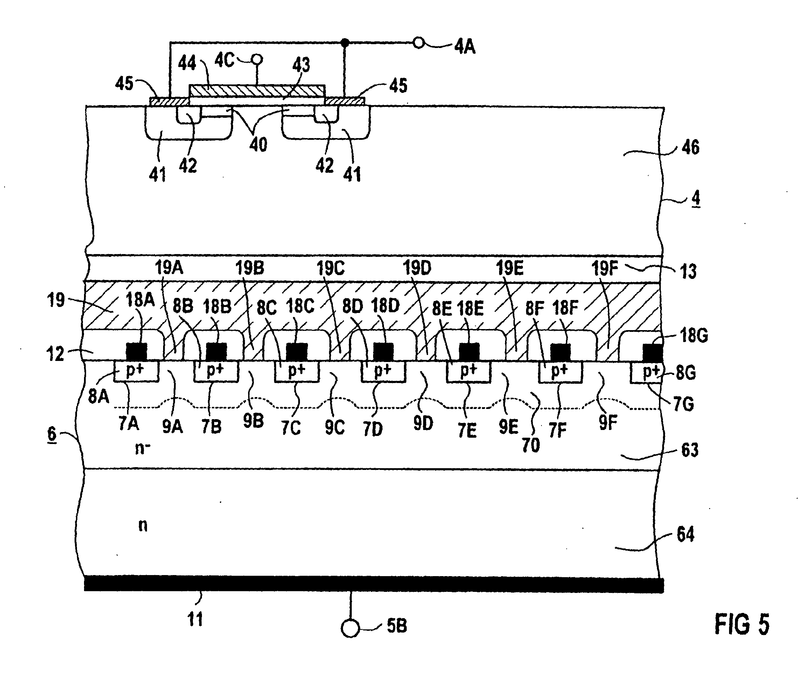

In der Ausführungsform der elektronischen Einrichtung gemäß FIG 5 sind eine wie in FIG 2 aufgebaute Halbleiteranordnung 5 und das Siliciumbauelement 4 zu einem Hybrid-Bauelement integriert. Über die den Halbleitergebieten 8A bis 8G der Halbleiteranordnung 5 zugeordneten Elektroden 18A bis 18G ist eine Isolationsschicht 12 aus einem dielektrischen Material, beispielsweise Siliciumdioxid, aufgebracht. Diese Isolationsschicht 12 ist in Bereichen über den Kanalgebieten 9A bis 9F mit Kontaktlöchern versehen. Auf die Isolationsschicht 12 ist eine Elektrodenschicht 19 aus einem elektrisch leitenden Material aufgebracht. Die durch die Kontaktlöcher in der Isolationsschicht 12 mit den Kanalgebieten 9A bis 9F kontaktierten Teile der Elektrodenschicht 19 bilden die einzelnen Elektroden 19A bis 19F. Eine solche Struktur ist mit Buried-Gate-Technik herstellbar. Auf die Elektrodenschicht 19 ist über eine Verbindungsschicht 13 das Siliciumbauelement 4 aufgebracht (gebonded). Zum Verbinden (Bonden) kann insbesondere eine Löttechnik (Chip-on-chip-Lötung), eine Bonddrahtverbindungstechnik oder auch direktes Waferbonding eingesetzt werden. Als Siliciumbauelement 4 ist beispielsweise ein an sich bekannter und deshalb nur schematisch dargestellter vertikaler MOSFET in DDMOS-Technik vorgesehen mit einem Siliciumwafer 46, mehreren in den Siliciumwafer 46 eindiffundierten Basisgebieten 41, in diese Basisgebiete 41 eindiffundierten Sourcegebieten 42, wenigstens einer über ein Isolatorgebiet 43 jeweils wenigstens einem Kanal 40 im Basisgebiet 41 zugeordneten Gateelektrode 44 und Sourceelektroden 45, über die die Sourcegebiete 42 und die Basisgebiete 41 elektrisch kurzgeschlossen sind.

In FIG 6 ist ein Schaltbild einer diskret aufbaubaren Ausführungsform der elektronischen Einrichtung dargestellt. Als Siliciumbauelement 4 ist ein Silicium-MOSFET, beispielsweise ein handelsüblicher Niedervolt-Leistungs-MOSFET, vorgesehen. Das Gate dieses MOSFET bildet den Steueranschluß 4C, die Source den mit dem ersten Anschluß 2 der elektronischen Einrichtung verbundenen ersten Anschluß 4A des Siliciumbauelements 4 und die Drain den zweiten Anschluß 4B des Siliciumbauelements 4. Die Halbleiteranordnung 5 ist mit dem Schaltungssymbol eines JFET dargestellt und kann beispielsweise wie in FIG 2 ausgebildet sein. Die Source des JFET bildet den ersten Anschluß 5A der Halbleiteranordnung 5 und ist somit mit der Drain des Silicium-MOSFET kurzgeschlossen. Die Drain des JFET bildet den zweiten Anschluß 5B der Halbleiteranordnung 5 und ist mit dem zweiten Anschluß 3 der elektronischen Einrichtung elektrisch verbunden. Das Gate des JFET bildet den dritten Anschluß 5C der Halbleiteranordnung 5 und ist mit dem ersten Anschluß 2 der elektronischen Einrichtung und der Source des Silicium-MOSFET elektrisch kurzgeschlossen. Mit einer solchen elektronischen Einrichtung, die als Hybrid-Leistungs-MOSFET bezeichnet werden kann, können insbesondere Sperrspannungen bis zu 5000 V und Nennströme (Durchlaßströme) zwischen 5 A und 500 A erreicht werden, wenn als Halbleitermaterial für die Halbleiteranordnung 5 Siliciumcarbid (SiC) verwendet wird.

Kombiniert man in einer nicht dargestellten weiteren vorteilhaften Ausführungsform der elektronischen Einrichtung eine Halbleiteranordnung 5 vom in der FIG 4 dargestellten IGBTartigen Hybrid auf Basis von Siliciumcarbid (SiC) mit einem Silicium-MOSFET, so können Sperrspannungen von bis zu 10 000 V und Nennströme zwischen 100 A und 1000 A erreicht werden.

Im allgemeinen wird die elektronische Einrichtung als elektronischer Schalter in eine elektrische Leitung oder einen Leitungsabzweig eines elektrischen Spannungsnetzes geschaltet zum Ein- und Ausschalten eines elektrischen Stromes für einen elektrischen Verbraucher.

Wird der Silicium-Leistungs-MOSFET durch einen sogenannten Smart-power-Silicium-MOSFET oder ein entsprechendes intelligentes Siliciumbauelement 4 zum Schalten ersetzt, so kann die elektronische Einrichtung außer mit Schaltfunktionen auch mit Schutzfunktionen, wie z. B. Überspannungsschutz oder Überstromabschaltung ausgestattet werden.

## Patentansprüche

1. Elektronische Strom-Schalteinrichtung mit zwei elektrischen Anschlüssen (2, 3) zum Anlegen elektrischer Betriebsspannungen (U) mit Maximalwerten von über 500 V, enthaltend ein Siliciumbauelement (4) und eine Halbleiteranordnung (5) aus Siliciumcarbid, die ein integriertes Hybrid-Bauelement bilden,
- wobei die Siliciumcarbid-Halbleiteranordnung (5) ein erstes fialbleitergebiet (6) eines vorgegebenen Leitungstyps, welches Halbleitergebiet (6) wenigstens ein Kanalgebiet (9; 9A, ...), das an wenigstens einen p-n-Übergang (7; 7A,7B, ...) angrenzt, aufweist, und wenigstens zwei weitere Halbleitergebiete (8A, 8B, ...) vom entgegengesetzten Leitungstyp wie das erste Halbleitergebiet (6) umfasst, welche weiteren weitere Halbleitergebiete (8A, 8B, ...) jeweils einen p-n-Übergang (7A, 7B, ...) mit dem ersten Halbleitergebiet (6) bilden, so dass das wenigstens eine Kanalgebiet (9; 9A, ...) von diesen p-n-Übergängen (7A, 7B; ...) begrenzt wird, wodurch bei der Siliciumcarbid-Halbleiteranordnung (5) zwischen den Halbleitergebieten (6; 8A,8B, ...) mit zueinander entgegengesetzten Leitungstypen jeweils p-n-Übergänge (7; 7A, 7B; ...) gebildet sind,
- und wobei die Halbleitergebiete (6, 8A, 8B: ...) der Siliciumcarbid-Halbleiteranordnung (5) mit dem Siliciumbauelement (4) elektrisch in Reihe zwischen die beiden Anschlüsse (2, 3) geschaltet sind, wodurch das Siliciumbauelement (4) bei Betriebsspannungen einer vorgegebenen Polarität in einem Durchlasszustand oder in einem Sperrzustand ist,
- und wobei wenigstens ein p-n-Übergang (7; 7A, 7B, ...) der Siliciumcarbid-Halbleiteranordnung (5) elektrisch zwischen die beiden Anschlüsse (2, 3) in Sperrrichtung für die Betriebsspannungen der vorgegebenen Polarität geschaltet ist und eine Verarmungszone (70) des wenigstens einen p-n-Übergangs (7; 7A, 7B, ...) im Sperrzustand des Siliciumbauelements (4) das wenigstens eine Kanalgebiet (9; 9A; ...) im ersten Halbleitergebiet (6) der der Siliciumcarbid-Halbleiteranordnung (5) abschnürt oder überdeckt.

2. Elektronische Einrichtung nach Anspruch 1, bei der das wenigstens eine weitere Halbleitergebiet (8A,8B) an einer ersten Oberfläche (61) des ersten Halbleitergebiets (6) angeordnet ist.

3. Elektronische Einrichtung nach Anspruch 2, bei der an einer von der ersten Oberfläche (61) des ersten Halbleitergebiets (6) abgewandten zweiten Oberfläche (62) des ersten Halbleitergebiets (6) eine Elektrode (11) angeordnet ist.

4. Elektronische Einrichtung nach Anspruch 2, bei der an einer von der ersten Oberfläche (61) des ersten Halbleitergebiets (6) abgewandten zweiten Oberfläche (62) des zusätzliches Halbleitergebiets (6) ein zusätzliches Halbleitergebiet (65) vom entgegengesetzten Leitungstyp (p bzw. n) wie das erste Halbleitergebiet (6) angeordnet ist und bei der an einer vom ersten Halbleitergebiet (6) abgewandten Oberfläche (66) dieses weiteren Halbleitergebiets (65) eine Elektrode (11) angeordnet ist.

5. Elektronische Einrichtung nach einem der vorhergehenden Ansprüche, bei der das Siliciumbauelement (4) eine MOS-Struktur zum Umschalten zwischen dem Durchlaßzustand und dem Sperrzustand enthält.

6. Elektronische Einrichtung nach Anspruch 5 mit einem Silicium-MOSFET als Siliciumbauelement (4).

## Claims

1. Electronic current-switching device with two electrical terminals (2, 3) for applying electrical operating voltages(U) with maximum values of over 500 V, containing a silicon component (4) and a semiconductor arrangement (5) made of silicon carbide which form an integrated hybrid component,
- with the silicon-carbide semiconductor arrangement (5) featuring a first semiconductor area (6) of a predetermined line type, said semiconductor area (6) comprising at least one channel area (9; 9A, ...), which adjoins at least one p-n junction (7; 7A, 7B, ...), and at least two further semiconductor areas (8A, 8B, ...) of the opposite line type to the first semiconductor area (6), with further semiconductor areas (8A, 8B, ...) each forming a p-n junction (7A, 7B, ...) with the first semiconductor area (6), so that the at least one channel area (9; 9A, ...) is delimited by these p-n junctions (7A, 7B; ...), through which p-n junctions (7; 7A, 7B; ...) are formed in each case for the silicon carbide semiconductor arrangement (5) between the semiconductor arrangement (6; 8A, 8B, ...) with opposing line types,
- and with the semiconductor areas (6, 8A, 8B ...) of the silicon carbide semiconductor arrangement (5) being connected electrically in series with the silicon component (4) between the two terminals (2, 3), through which the silicon component (4) is in an on state or an off state for operating voltages of a predetermined polarity,
- and with at least one p-n junction (7; 7A, 7B, ...) of the silicon carbide semiconductor arrangement (5) being connected electrically between the two terminals (2, 3) in the off-state direction for the operating voltages of the predetermined polarity and a depletion zone (70) of the at least one p-n junction (7; 7A, 7B, ...) in the off state of the silicon component 4) cutting off or covering the at least one channel area (9; 9A; ...) in the first semiconductor area (6) of the silicon carbide component (5).

2. Electronic device in accordance with claim 1, in which the at least one further semiconductor area (8A, 8B) is arranged on a first surface (61) of the first semiconductor area (6).

3. Electronic device in accordance with claim 2, in which an electrode (11) is arranged on a second surface (62) facing away from the first surface (61) of the first semiconductor area (6).

4. Electronic device in accordance with claim 2, on which an additional semiconductor area (65) of the opposite line type (p or n) to the first semiconductor area (6) is arranged on a second surface (62) facing away from the first surface (61) of the first semiconductor area (6) and for which an electrode (11) is arranged on a surface (66) of this further semiconductor area (65) facing away from the first semiconductor area (6).

5. Electronic device in accordance with one of the previous claims, in which the silicon component (4) contains an MOS structure for switching between the on state and the off state.

6. Electronic device in accordance with claim 5 with a silicon MOSFET as the silicon component (4).

## Revendications

1. Dispositif électronique pour la commutation de courant, muni de deux connexions électriques (2, 3) pour appliquer des tensions de service électriques (U) ayant des valeurs maximales de plus de 500 V, comprenant un composant au silicium (4) et un dispositif à semi-conducteurs (5) au carbure de silicium qui forment un composant hybride intégré,
- le dispositif à semi-conducteurs au carbure de silicium (5) comprenant une première zone de semi-conducteurs (6) d'une nature de conductivité prédéterminée, laquelle zone de semi-conducteurs (6) présente au moins une zone de canal (9 ; 9A, ...) qui est adjacente à au moins une jonction pn (7 ; 7A, 7B, ...), et comprenant au moins deux autres zones de semi-conducteurs (8A, 8B, ...) de nature de conductivité inverse à la première zone de semi-conducteurs (6), lesquelles autres zones de semi-conducteurs (8A, 8B, ...) forment respectivement une jonction pn (7A, 7B, ...) avec la première zone de semi-conducteurs (6), de sorte que l'au moins une zone de canal (9 ; 9A, ...) est limitée par ces jonctions pn (7A, 7B ; ...), sur quoi dans le dispositif à semi-conducteurs au carbure de silicium (5), des jonctions pn (7 ; 7A, 7B ; ...) à natures de conductivité inverses sont respectivement formées entre les zones de semi-conducteurs (6 ; 8A, 8B, ...),
- et les zones de semi-conducteurs (6, 8A, 8B ; ...) du dispositif à semi-conducteurs au carbure de silicium (5) étant électriquement couplées en série au composant au silicium (4) entre les deux connexions (2, 3), sur quoi le composant au silicium (4), en cas de tensions de service d'une polarité prédéterminée, est dans un état passant ou dans un état bloqué,
- et au moins une jonction pn (7 ; 7A, 7B, ...) du dispositif à semi-conducteurs au carbure de silicium (5) étant commutée électriquement entre les deux connexions (2, 3) en direction de blocage pour les tensions de service de la polarité prédéterminée et une zone d'appauvrissement (70) de l'au moins une jonction pn (7 ; 7A, 7B, ...), à l'état bloqué du composant au silicium (4), bloquant ou recouvrant l'au moins une zone de canal (9 ; 9A ; ...) située dans la première zone de semi-conducteurs (6) du dispositif à semi-conducteurs au carbure de silicium (5).

2. Dispositif électronique selon la revendication 1, dans lequel l'au moins une autre zone de semi-conducteurs (8A, 8B) est disposée sur une première surface (61) de la première zone de semi-conducteurs (6).

3. Dispositif électronique selon la revendication 2, dans lequel une électrode (11) est placée sur une deuxième surface (62) détournée de la première surface (61) de la première zone de semi-conducteurs (6).

4. Dispositif électronique selon la revendication 2, dans lequel, sur une deuxième surface (62) de la zone supplémentaire de semi-conducteurs (6), détournée de la première surface (61) de la première zone de semi-conducteurs (6) est disposée une zone supplémentaire de semi-conducteurs (65) de nature de conductivité inverse (p resp. n) à la première zone de semi-conducteurs (6) et dans lequel une électrode (11) est placée sur une surface (66) de cette zone supplémentaire de semi-conducteurs (65), détournée de la première zone de semi-conducteurs (6).

5. Dispositif électronique selon l'une quelconque des revendications précédentes, dans lequel le composant au silicium (4) comprend une structure MOS pour commuter entre l'état passant et l'état bloqué.

6. Dispositif électronique selon la revendication 5, comprenant un MOSFET au silicium en tant que composant au silicium (4).
